# EUROPEAN PATENT APPLICATION

(11) **EP 1 916 694 A1**
(43) Date of publication of application: **30.04.2008**
(21) Application number: 06022327.8
(22) Date of filing: 25.10.2006
(51) Int. Cl.: H01J 37/09

(54) **Adjustable aperture element for particle beam device, method of operating and manufacturing thereof**

(71) Applicant: ICT, Integrated Circuit Testing Gesellschaft für Halbleiterprüftechnik Mbh, 85551 Heimstetten (DE)
(72) Inventor: Lanio, Stefan, 85435 Erding (DE); Schmitt, Reinhold, 81739 München (DE)
(74) Representative: Zimmermann, Gerd Heinrich

(57) **Abstract**

A charged particle beam device is provided. The device includes an emitter for emitting a charged particle beam in a propagation direction essentially along an optical axis of the charged particle beam device, an aperture arrangement within the charged particle beam device. The aperture arrangement (100) includes a first aperture element (102) having a recess of the first aperture element, the first aperture element being movable in a first direction and with respect to the optical axis, a second aperture element having a recess of the second aperture element, the second aperture element (104) being movable in essentially the first direction and with respect to the optical axis, a holder for holding the first aperture element and the second aperture element, a motion element adapted to move the first aperture element and the second aperture element with respect to the optical axis, and wherein the first aperture element and the second aperture element are displaced with respect to each other along the propagation direction, wherein the first aperture element and the second aperture element are movable in the first direction such that the recess of the first aperture element and the recess of the second aperture element form an aperture opening of a variable size.

## Description

### FIELD OF THE INVENTION

The invention generally relates to a charged particle beam device and a method of imaging specimen with a charged particle beam, particularly for inspection applications, testing applications, lithography applications and the like. More particularly, it relates to a charged particle beam device, a use of an aperture arrangement for a charged particle beam device, and a method of manufacturing an aperture arrangement for a charged particle beam device.

### BACKGROUND OF THE INVENTION

Charged particle beam apparatuses have many functions in a plurality of industrial fields, including, but not limited to, inspection of semiconductor devices during manufacturing, exposure systems for lithography, detecting devices and testing systems. Thus, there is a high demand for structuring and inspecting specimens within the micrometer and nanometer scale.

Micrometer and nanometer scale process control, inspection or structuring, is often done with charged particle beams, e.g. electron beams, which are generated and focused in charged particle beam devices, such as electron microscopes or electron beam pattern generators. Charged particle beams offer superior spatial resolution compared to, e.g. photon beams, due to their short wavelengths.

Charged particle beam device typically include an aperture for beam current control. Contaminations on the aperture can change the current and the trajectory trespassing through an aperture diaphragm. In order to counteract such influences and to further control the beam current different aperture openings and aperture sizes may be provided, e.g., in a multi aperture unit. Further, by controlling the beam current the spot size on a specimen can be further adjusted. Depending on the position of the aperture opening, that is whether the aperture opening is on-axis or off-axis, aberrations in the system may also be considered.

### SUMMARY OF THE INVENTION

In light of the above, the present invention intends to provide an improved charged particle beam device, an improved method of operating a charged particle beam device and a method of manufacturing the charged particle device.

The object is solved by the charged particle device according to independent claim 1, by the use of a charged particle beam device according to independent claim 12, and by the method according to independent claim 19.

According to one embodiment, a charged particle beam device is provided. The charged particle beam device includes an emitter for emitting a charged particle beam in a propagation direction essentially along an optical axis of the charged particle beam device, and an aperture arrangement within the charged particle beam device. The aperture arrangement includes a first aperture element having a recess of the first aperture element. The first aperture element is movable in a first direction and with respect to the optical axis. The aperture arrangement includes a second aperture element having a recess of the second aperture element. The second aperture element is movable in essentially the first direction and with respect to the optical axis. The aperture arrangement includes a holder for holding the first aperture element and the second aperture element, a motion element adapted to move the first aperture element and the second aperture element with respect to the optical axis. The first aperture element and the second aperture element are displaced with respect to each other along the propagation direction, and the first aperture element and the second aperture element are movable in the first direction such that the recess of the first aperture element and the recess of the second aperture element form an aperture opening of a variable size.

According to another embodiment, a use of an aperture arrangement for a charged particle beam device adapted for variably controlling a beam current of a charged particle beam trespassing in a propagation direction essentially along on optical axis of the charged particle beam device is provided. The use includes moving a first aperture element and a second aperture element in a first direction with respect to each other such that a recess of the first aperture element and the recess of the second aperture element form an aperture opening of a variable size for trespassing of the charged particle beam, the aperture opening being located essentially on the optical axis.

According to a further embodiment, a method of manufacturing an aperture arrangement for a charged particle beam device adapted for variably controlling a beam current of a charged particle beam trespassing in a propagation direction essentially along on optical axis of the charged particle beam device, including: providing a first aperture element and a second aperture element with a fixed position relative to each other with regard to the optical axis, and thereafter forming a recess of the first aperture element and a recess of the second aperture element.

Further advantages, features, aspects and details that can be combined with the above embodiments are evident from the dependent claims, the description and the drawings.

According to the embodiments described herein, a charged particle device including an aperture arrangement with variable size is provided. Further, the aperture arrangement may be provided to be contamination free and with a current control feedback mechanism.

Embodiments are also directed to apparatuses for carrying out the disclosed methods and including apparatus parts for performing each described method steps. These method steps may be performed by way of hardware components, a computer programmed by appropriate software, by any combination of the two or in any other manner. Furthermore, embodiments are also directed to methods by which the described apparatus operates. It includes method steps for carrying out every function of the apparatus or manufacturing every part of the apparatus.

### BRIEF DESCRIPTION OF THE DRAWINGS

Some of the above indicated and other more detailed aspects of the invention will be described in the following description and partially illustrated with reference to the figures. Therein:

Fig. 1A shows a schematic view of parts of a first embodiment of a an aperture arrangement including two aperture elements which can be moved with respect to each other;

Fig. 1B is a schematic perspective view of an embodiment as shown in Fig. 1A;

Fig. 2 shows an embodiment of an aperture arrangement including a motion element and two movable aperture elements;

Fig. 3 shows parts of another embodiment of an aperture arrangement;

Figs. 4A and 4B illustrate the size variation of aperture openings formed by recesses within two aperture elements;

Fig. 5 shows a schematic view of an intermediate product for manufacturing an aperture arrangement;

Fig. 6 shows a schematic view of an operational mode of an aperture arrangement;

Fig. 7 shows a schematic view of aperture elements according to a further embodiment including heating means for a contamination free aperture;

Fig. 8 shows a schematic view of an embodiment of a charged particle beam device including a variable on-axis aperture and a current control feedback; and

Fig. 9 shows another embodiment of a charged particle beam device including an aperture arrangement according to any of the embodiments described herein.

### DETAILED DESCRIPTION OF THE DRAWINGS

Without limiting the scope of the present application, in the following the charged particle beam device or components thereof will exemplarily be referred to as an electron beam device or components thereof. Thereby, the electron beam might especially be utilized for inspection or lithography. The present invention can still be applied for apparatuses and components using other sources of charged particles and/or other secondary and/or backscattered charged particles to obtain a specimen image or to pattern a specimen.

Within the following description of the drawings, the same reference numbers refer to the same components. Generally, only the differences with respect to the individual embodiments are described.

A "specimen" as referred to herein, includes, but is not limited to, semiconductor wafers, semiconductor workpieces, and other workpieces such as optical blanks, memory disks and the like. Embodiments of the invention may be applied to any generally flat workpiece on which material is deposited or which are structured. A specimen includes a flat surface to be structured or on which layers are deposited, an opposing surface, an edge, and typically a bevel.

An "aperture" as referred to herein, is not to be understood as any kind of opening, like a lens mount, a part of the column housing or parts that might theoretically delimit a beam. An aperture is to be understood as an optical aperture that is introduced in order to delimit the size of a charged particle beam, i.e. an aperture diaphragm. In light thereof, the aperture opening may generally be considered to be smaller than 1 mm, e.g., 2 µm to 700 µm, for a charged particle beam application.

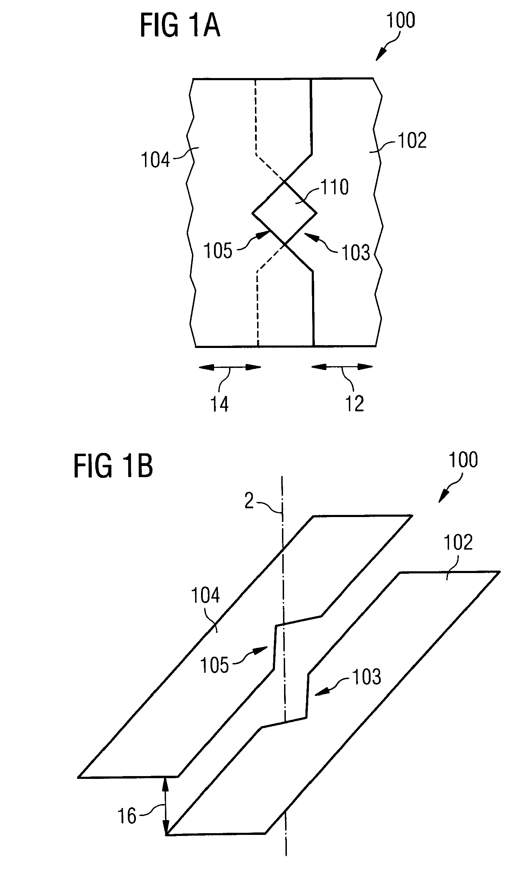

Figs. 1A and 1B illustrate parts of a first embodiment. An aperture arrangement 100 includes a first aperture element 102 and a second aperture element 104. As shown in Fig. 1A, the first aperture element 102 and the second aperture element 104 overlap each other. Each aperture element has a straight edge portion on the side opposing the other aperture element and may include a recess on the side opposing the other aperture element, respectively. The aperture element 102 has a recess 103. The recess 103 has a triangular shape. The aperture element 104 has a recess 105. The recess 105 has a triangular shape. The overlapping aperture elements 102 and 104 form an aperture opening 110. Thereby, the triangular recesses form an essentially quadratic opening.

The aperture element 102 is movable as indicated by arrow 12. The aperture element 104 is movable as indicated by arrow 14. By moving the aperture elements with respect to each other along the same direction, the opening 112 is variable and has a continuously adjustable aperture opening size. Thereby, the aperture arrangement 100 including the aperture elements 102 and 104 includes a quadratic aperture opening 110 with an adjustable size.

According to one embodiment, the triangular recesses 103 and 105 have an angle of 90 degrees at their inner corner. Thereby, during movement according to arrows 12 and 14, the shape of the aperture opening 110 maintains essentially quadratic.

The shapes of the recesses and aperture openings described herein may vary from the theoretical shape in light of the manufacturing precision and the precision that can be realized when moving the aperture elements with respect to each other. Thus, for example, a quadratic shape is to be understood as essentially quadratic. This includes a deviation from a square of, for example, 10% or the like.

Generally, embodiments described herein provide a continuous variation of the aperture opening size as compared to discrete values in common system.

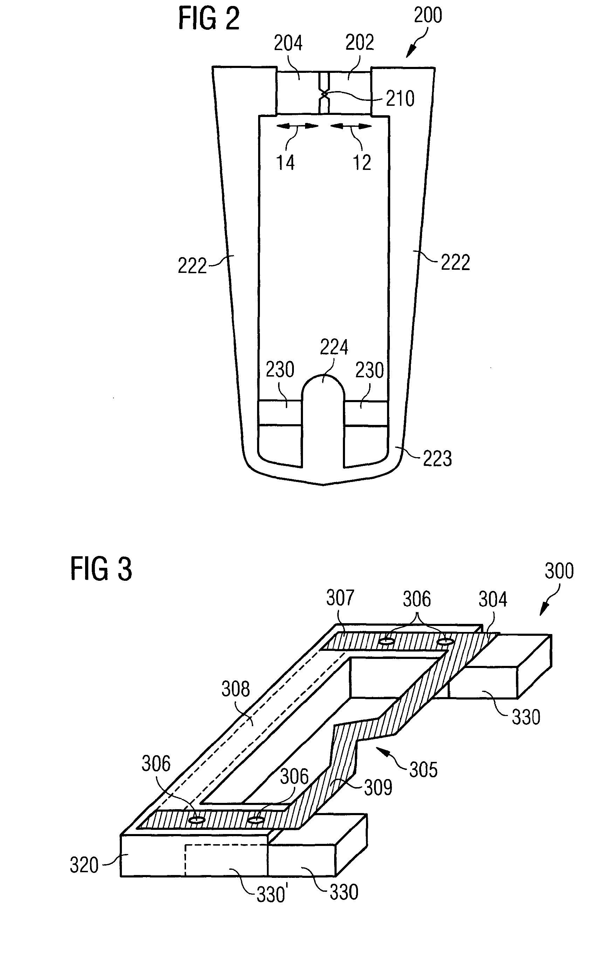

Within the embodiments described herein, the recesses forming the aperture opening are moved in essentially the same direction (small deviations may occur for example by a lever arm as described with respect to Fig. 2). Further, they may be moved symmetrical with respect to the center of the aperture opening. Thereby, the center of the aperture opening remains at the same location in the electron beam device. According to one embodiment, the center of the aperture opening is positioned onto the optical axis of the device or the optical axis of the device is at least located within the area of the aperture opening. Further, the embodiments illustrating quadratic aperture openings provide a congruent aperture opening shape independent of the aperture opening size.

Generally, scanning electron beam devices provide a resolution of the system that is dependent from the spot size of the electron beam on a specimen. Many electron beam device have a spot size that is limited by the beam current in the electron beam. Therefore, if a beam current limiting aperture is provided the spot size on the specimen varies dependent from the size of the aperture opening. Providing a multi-aperture arrangement with different aperture sizes allows for beam currents with discrete predetermined values. (For example two, four or eight different aperture sizes.) The movable aperture elements with recesses according to the embodiments described herein allow a continuous adjustment of the beam current and, thereby, the spot size.

According to another embodiment, different shapes of recesses may be used. Thereby, however, the shape of the opening 110 generally varies when the overlapping aperture elements 102 and 104 are moved with respect to each other. For example, the recesses may be elliptical or may have a different triangular shape. Thereby, openings with an elliptical contour or rectangular openings, respectively, may be realized. According to another embodiment, one aperture element may have a recess with the triangular shape and a 60° angle at its inner side. The other aperture element may have no recess. Thereby, also an opening with varying size and a congruent shape may be realized.

Fig. 1B is a perspective view showing parts of the aperture arrangement 100. Fig. 1B shows the optical axis 2 of the system, the aperture element 102 and the aperture element 104. Each aperture element has a recess 103 and 105. As indicated by arrow 16, the aperture element 102 and 104 are displaced along optical axis 2.

According to one embodiment, the aperture elements 102 and 104 are displaced by a distance of about 200 µm. Thereby, sufficient distance is provided in order not to disturb the relative movement of the aperture elements. According to another embodiment, the aperture elements are displaced by a distance of 0.5 mm to 1.5 mm. Thereby, a safety margin is provided. This avoids any sliding or rubbing contact between the aperture elements, which may produce particles that can contaminate the environment in the electron beam device. According to an even further embodiment, even higher distances up to, for example, 2 mm may be provided. Large displacements of the two aperture elements may however disturb the optical characteristics of the electron beam device. The distance used for specific applications may depend upon the fact, whether the aperture opening is beam-current-limiting only or if the aperture opening is imaged in an image plane.

Fig. 2 illustrates another embodiment of an aperture arrangement 200 including a first aperture element 202 and a second aperture element 204. The aperture elements each have a recess, as described with respect to Figs. 1A and 1B, which form an opening 210. Each of the aperture elements are mounted to one of the lever arms 222, respectively. The lever arms of the holding element (holder) are movable at pin-joints 223, respectively. According to one embodiment, the pin-joint is provided within a one-piece structure, whereby the thickness of the structure at the position of the pin-joint is weak enough to allow a movement of the lever arms.

The movement of the lever arms is introduced by motion elements 230. According to one embodiment, the motion elements 230 are piezo elements. The piezo elements are mounted between a fixed part 224 of the holder and the level arms 222. The movement of the piezo elements 230 moves the lever arms 222. Thereby, the aperture elements 202 and 204 are moved with respect to each other as indicated by arrows 12 and 14. The lever arms enlarge the movement of the piezo elements 230. Thereby, a small movement of the piezo elements can result in a sufficiently large movement of the aperture elements.

Within the embodiment shown in Fig. 2, the height of the aperture arrangement, that is the dimension along the optical axis, can be particularly small in the area of the electron beam. For example, the aperture elements and the parts of the lever arms to which the aperture elements 202 and 204 are mounted may have a height that is between 3 mm and 10 mm. Thereby, no additional column length needs to be provided on the optical axis because the aperture arrangement can be position between existing parts without providing additional space.

According to a further embodiment, the portion of the lever arms and the motion element, which are further distant from the aperture opening, may have an increased height without influencing the installation height (the optical path length) of the electron beam device.

According to one embodiment, the aperture opening 210 should be variable between 5 µm and 500 µm. Depending on the length of the lever arms 222, the movement of one aperture element by at least a few hundred µm can be realized by the piezo elements 230. According to another embodiment, the movements of the aperture elements are conducted symmetrical such that the aperture opening 210 remains essentially at the same position.

According to further embodiments, the piezo elements 230 may be replaced by other actuators, as for example actuators based on a magneto-rheological effect. As another example, magneto restrictive actuators may be used. Also electro-rheological elements may be used to introduce the movement of the aperture elements 202 and 204.

According to a further embodiment, only a single motion element 230 is provided for movement of the aperture elements. Thereby, the movement of the motion element requires reduced or no control. For example piezo elements have a small movement increment (high relative precision) in the nanometer range. However, an absolute positioning precision is low which requires a control mechanism to define the actual position of the motion element. Such a control that may have more importance if two motion elements need to be synchronized in their movement may be omitted if only one element is used. Depending on the ratio between the movement of the motion element and the movement of the aperture element an absolute positioning control may also be omitted if two motion elements are provided.

Fig. 3 illustrates a part of another embodiment of an aperture arrangement 300. The aperture arrangement 300 includes a holder 320. Thereon, aperture element 304 is mounted. The holder is provided in a U-shaped form to receive an aperture element. The second aperture element is provided on a further U-shaped holder portion.

The aperture element 304 includes a mounting portion 307. The mounting portion 307 includes openings 306, which are used to mount the aperture element 304 on the holder 320. The aperture element 304 further includes an aperture forming portion 309 including the recess 305. The aperture forming portion 309 is overlapped by an aperture forming portion of a further aperture element, thereby forming an aperture opening with a variable size. The aperture element 304 further includes a portion 308, which is indicated by dashed lines. The dashed lines illustrate the fact that the portion 308, which is mainly utilized to stabilize the aperture element, may be removed after the aperture element 304 has been mounted on the holder 320.

According to one embodiment, the mounting portion has a width of 5 mm to 10 mm in order to provide a sufficiently large area for mounting of the aperture element. The aperture forming portion may have a width of 2-3 mm.

The aperture arrangement 300 further includes motion element 330. The motion element 330 can be a piezo electric element. However, according to further embodiments, other motion elements, as described with respect to Fig. 2, may be utilized.

The motion element 330 is in contact with the holder 320, as illustrated in Fig. 3. On the right hand side of the motion element (not shown) a further portion of the holder is provided for holding the further aperture element. The motion element, for example a piezo element, changes its length in order to move the portions of the holder with respect to each other. As indicated by dashed lines (see, 330') the piezo element may be enlarged in order to provide an enlarged movement range for the two aperture elements 304 with respect to each other. According to one embodiment, if a piezo element is provided between two U-shaped holding portions or between two lever arms of a holder, the piezo element or the motion element in general has a symmetrical travel.

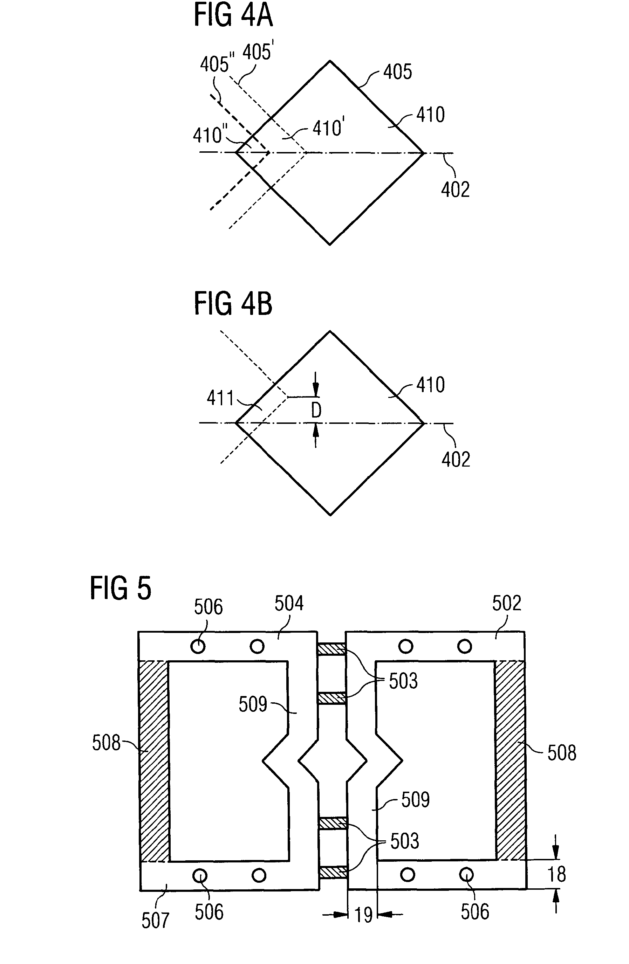

Figs. 4A and 4B illustrate the variable aperture openings 410 and problems that might be associated therewith. As shown in Fig. 4A, the aperture opening 410 is formed by the triangular recesses. One of them is illustrated by reference numeral reference 405. If the aperture elements and, thereby, the edges of the recesses are moved with respect to each other along axis 402, the opening can be, e.g., reduced in size to provide an opening 410' or 410". The movement of the recess 405 relative to the other recess is indicated by dashed lines 405' and 405".

As shown in Fig. 4B, a small displacement D with respect to axis 402 during the movement of one of the aperture elements might result in a significant deformation of the aperture opening 410. Within Fig. 4B, the opening 411 is significantly deformed from the quadratic shape, which is desired as an aperture opening, according to the provided example.

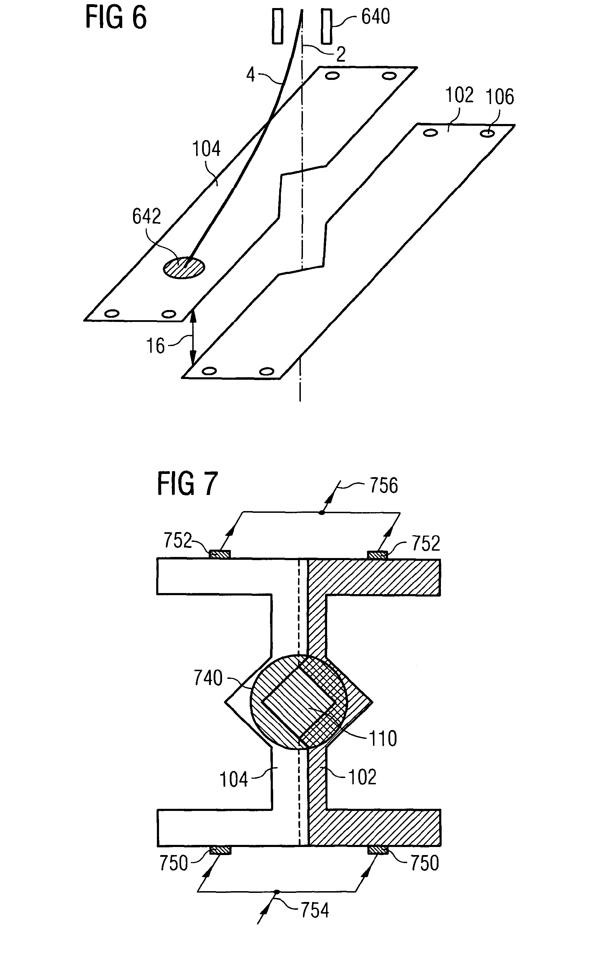

In order to avoid a situation as shown in Fig. 4B, a high assembly precision is required to obtain a desired shape and size of the aperture opening. Therefore, an improved assembly method needs to be provided. An intermediate product for assembling an aperture arrangement is illustrated in the embodiment shown in Fig. 5. Within Fig. 5, the first aperture element 502 and a second aperture element 504 is shown. The aperture elements include bar-shaped portions 507 extending essentially along the direction, in which the aperture elements are moved with respect to each other 507. On each of the aperture element portions 507 openings 506 for mounting the aperture elements onto the holder are provided. Further, reinforcement portions 508 are provided for each of the aperture elements 502 and 504. The aperture forming portions 509 are located next to each other, whereby connecting portions 503 are provided between the aperture forming portion 509 of aperture element 504 and the aperture forming portion 509 of aperture element at 502. Thus, the aperture elements have a fixed position relative to each other. During manufacturing of the recesses in the aperture elements, for example, by etching, laser cutting, etc., and during mounting of the aperture elements on the holder no lateral displacement of the aperture elements with respect to each other may occur until the aperture arrangement is finally assembled.

According to one embodiment, the aperture elements 502 and 504 are mounted on a holder. The connecting portions 503 ensure a fixed position relative to each other. Further, reinforcement portions 508 provide additional stability during mounting of the aperture elements 502 and 504 onto the holder.

The aperture elements 502 and 504 may be mounted and fixed to the holder by screws provided through openings 506. According to another embodiment, the aperture elements may be welded or glued to the holder. Other fixing means can additionally or alternatively be provided.

After the aperture elements 502 and 504 are fixedly mounted on the holder, the connecting elements 503 can be removed. Further, the reinforcement portions 508 can be removed after the aperture elements are fixedly mounted on the holder.

In light of the above, by providing at least connecting elements 503 between the aperture element 502 and the aperture element 504, the precision, which can be realized during manufacturing of the aperture elements including the recesses, can be carried forward to the aperture arrangement without introducing any displacement during mounting of the aperture elements on the holder.

According to another embodiment (not shown), the manufacturing precision of the aperture elements can also be carried forward to the aperture assembly by first mounting a sheet or two sheets, respectively, on a holder for the aperture arrangement and, afterwards, forming the other portions of the aperture elements including the recesses, which provide the aperture opening of the aperture arrangement, in the sheet fixedly mounted on the holder. Thereby, after separating of the sheet into the first aperture element including the first recess and a second aperture opening including a second recess, the manufacturing precision of the recesses can be carried forward to the aperture arrangement.

Within Fig. 5, a width 18 of the mounting portion 507 of the aperture elements 502 and 504 is indicated. Generally, in the embodiments described herein, the width 18 of the mounting portion 507 of the aperture elements is between 5 mm and 10 mm. Thereby, a sufficiently strong connection for mounting the aperture elements on the holder can be provided. The strength of the connection of the aperture elements to the holder partly determines the assembly precision and the precision of the aperture arrangement.

Width 19 of the aperture forming portion 509 of the aperture elements 502 and 504 may typically be in the range of 2 mm to 3 mm for the embodiments described herein. The width 19 of the aperture forming portion of the aperture elements determines, after removal of the reinforcement portions 508, the stability of the aperture arrangement, and further influences the heating characteristic of the aperture arrangement. The heating of the aperture arrangement will be described for example with respect to Fig. 7.

Fig. 6 illustrates another embodiment. Therein, a further advantage of embodiments described herein is illustrated. Within Fig. 6, aperture element 102 and aperture element 104 are shown. The aperture elements have openings 106 for mounting the aperture elements to a holder. The aperture elements are displaced with respect to each other along an optical axis 2, as indicated by arrow 16. Reference numeral 640 denotes a deflection system which deflects the beam away from the optical axis 2. Thereby, the electron beam 4 impinges on the aperture element 104. Alternatively, according to another embodiment, the electron beam 4 can also impinge on the other aperture element 102 or both aperture elements 102 and 104.

Within Fig. 6, the electron beam 4 hits the aperture arrangement in a parking position or blanking position. Thus, the electron beam can not pass through the aperture arrangement. The parking position or blanking position, which is indicated as position 624, provides an electron beam system, for which the electron beam does not trespass the aperture arrangement. Thus, the electron beam for can be entirely blanked utilizing the aperture arrangement.

As described above, within Fig. 6, a deflection unit is shown. The deflection unit can deflect the electron beam onto a part of the aperture element such that the beam can not trespass towards a specimen. The beam is guided onto a parking position located onto at least one element of the group consisting of: the first aperture element and the second aperture element. Thereby, the beam can be entirely blocked.

According to another embodiment, the aperture opening with the variable size is entirely closed and a beam deflection unit may be omitted according to this embodiment. The beam is guided onto a parking position located onto at least one element of the group consisting of: the first aperture element and the second aperture element. By entirely closing the aperture opening, the beam can be entirely blocked.

However, a parking/blanking position on the aperture arrangement may influence the aperture arrangement. On impingement of the electron beam 4, the aperture arrangement can be contaminated. Contaminations on an aperture element or on one of the aperture elements influences the imaging properties of the electron beam system because contaminations tend to be charged and, thereby, provide an electric field acting on the electron beam. Further, if the contamination built-up is further increased the aperture opening itself, that is the shape thereof, can be distorted.

A cleaning mechanism for the aperture arrangement is provided according to the embodiment shown in Fig. 7 such that a contamination free aperture arrangement can be provided.

The aperture elements 102 and 104 are resistively heated to avoid contamination built-up. As shown in Fig. 7, the aperture elements 102 and 104 have connectors 754 for providing a current to the aperture arrangement and connectors 752 for providing a current to the aperture arrangements.

According to the embodiment shown in Fig. 7, the current is provided through lines 745 over terminals 750 through aperture elements 102 and 104, respectively, through terminals 752 and line 756 (parallel connection). Thereby, each of the aperture forming portions of the aperture elements are resistively heated by the same current and each fraction of the aperture elements, respectively, opposing the other aperture element is on the same potential. Thereby, in the event the aperture elements would contact each other due to a close distance, due to a thermal expansion or the like, no shortcut which influences the heating would be provided.

According to one embodiment, a continuous heating might be conducted by heating the aperture element 102 and the aperture element 104 continuously to a temperature of about 150 °C to 250 °C. Thereby, however, the fields introduced by the heating currents may deteriorate the imaging properties of the electron beam device during operation.

Therefore, according to another embodiment, typically a flash heating can be provided. The flash heating uses heating during a limited period of time, e.g., 60 seconds. During the heating flash, the aperture elements are heated to temperatures in a range of 500 °C to 700°C. Typically, for a flash heating, the electron beam device is not generating images during the time of heating.

Additionally or alternatively the heating flashes might be provided for an even shorter time period, e.g., 1 second or below. Thereby, the currents within the aperture elements can be provided for example during a time where the electron beam is swept back between scanning of two lines. Further, the heating current, that is the flashes of heating currents, can be applied at those time periods when the system is not producing an image, i.e., a non-imaging mode. As a result, the magnetic field associated with the heating currents will not influence the electron beam.

As described with regard to Fig. 5, the width of the mounting portion of the aperture elements is between 5 mm and 10 mm. Thereby, a sufficiently strong connection for mounting the aperture elements on the holder can be provided. The strength of the connection of the aperture elements to the holder partly determines the assembly precision and the precision of the aperture arrangement.

The width of the aperture forming portion of the aperture elements may typically be in the range of 2 mm to 3 mm for the embodiments described herein. The width of the aperture forming portion of the aperture elements determines, after removal of the reinforcement portions, the stability of the aperture arrangement, and further influences the heating characteristic of the aperture arrangement.

Therefore, according to one embodiment, the width of the strip of sheet material of the aperture forming portion of the aperture element is the same in the recess portion and the portion including the straight edge opposing the other aperture element. Thus, the resistivity of the sheet is the same along the path of the aperture forming portion of the aperture element. In light thereof a constant heating can be provided.

In light of the limited width of the aperture forming portion of the aperture element it should also be noted that according to one embodiment the reinforcement portion of the aperture element is removed after mounting on the holder because the reinforcement portion would require additional current for resistively heating the aperture element.

Further, the aperture elements including portions with a relatively small width provide only a little mass. Thereby, the aperture can be heated more easily and can cool faster without heating a larger area of the surround portions of the electron beam device as necessary. The displacements of the first and the second aperture elements, which has been described with respect to other embodiments, may also be adapted such that the aperture elements do not get into rubbing contact with each other when the aperture elements, which are fixed at the mounting portions thereof, are subject to thermal expansion and bend upward or downward in direction of the optical axis.

Within Fig. 7, the electron beam, which is indicated by reference 740, is partly blocked by the aperture opening 110. The heating of the aperture elements 102 and 104 prevents contamination of the area of the aperture forming portions of the aperture elements. Thus, the contamination of a parking position and an area around the aperture opening can be prevented. The heating of the two aperture elements with a parallel connected current improve the heating characteristics of the aperture arrangement including two elements, which are displaced with respect to each other along an optical axis. This might be particularly relevant, if the two aperture elements 102 and 104 are located close to each other with respect to the propagation direction.

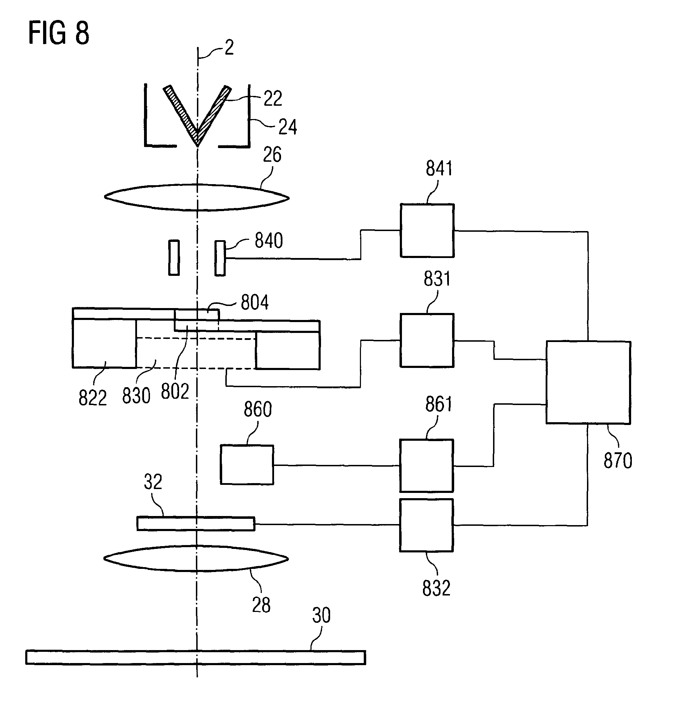

Fig. 8 illustrates an embodiment of an electron beam device. The electron beam device emits electrons with electron emitter 22 along optical axis 2. The suppressor 24 influences the beam current and/or the beam characteristics. The electron beam is guided through the column of the electron beam device by condenser lenses 26 and objective lens 28. The electron beam is guided onto specimen 30.

Within Fig. 8, aperture elements 802 and 804 provide an aperture opening for blanking a portion of the beam. Thereby, only a predetermined amount of electrons can trespass through the opening and the beam current can be adjusted. The beam current can be adjusted by varying the size of the opening due to motion element 830. The aperture elements 802 and 804 are located on holding portions 822. On impingement of primary electrons on specimen 30, secondary and/or backscattered particles are released from the specimen 30. The secondary and/or backscattered particles can be detected by detector 32. The embodiment shown in Fig. 8, further illustrates a deflection unit 840 and a beam current measurement device 860.

The beam current measurement device 860 can be a Faraday cup or other means for measuring the beam current. Thereby, deflection unit 840 or other deflection units can be used to deflect the electron beam onto the beam current measurement device. According to another embodiment, the beam current may be determined by the intensity of the secondary and/or backscattered particles measured from a reference sample as a specimen. Further, the deflection unit 840 can further be utilized to deflect the electron beam from the optical axis 2 onto a parking position on the aperture arrangement.

The elements described above, are associated with respective controllers or sensing systems. Deflection unit 840 is controlled by deflection unit controller 841. Motion element 830 is controlled by motion element controller 831. Beam current measuring device 860 is controlled by beam current measuring device controller 861. The beam current measuring device controller 861 also receives the signals from the beam current measurement device 860 and provides a corresponding signal value to the general system controller 870. Detector 32 is controlled by detector controller 832 and, accordingly, receives signals by the detector and provides the signals to the system controller 870. The system controller 870 determines the beam current after the aperture arrangement based on input signals from the beam current measuring device controller 861 and/or detector controller 832. Thereby, the system controller 870 can provide a signal towards motion element controller 831 for controlling the motion element of the aperture arrangement. Thus, a feedback loop for controlling the beam current of the electron beam device can be provided. Independent of other influences of the electron beam device, the aperture opening of the aperture arrangement can be varied in size in order to have a constant beam current on the specimen.

In light of the above, the control of the aperture opening may also be improved. Generally, if for example a piezo element is used for varying the size of the aperture arrangement, the piezo element might require an absolute positioning control feedback to provide an absolute positioning precision. Piezo elements can provide movement of the aperture elements with a very small increment. However, the absolute positioning position is low.

In light of the current measurement feedback control, according to one embodiment, a positioning detection element for the motion element can be omitted because the absolute positioning precision of the motion element 830, which determines the size of the aperture opening, is not necessarily used for controlling the aperture arrangement. Instead, the beam current trespassing the aperture arrangement, can be used for controlling the motion element 830 of the aperture arrangement.

According to one embodiment, a feedback of a beam current measurement to adapt the size of the continuously varying aperture opening size can be provided during an alignment procedure of the system, e.g., once a day. Thereby, during each alignment of the system the beam current is adjusted by varying the aperture opening size. According to yet another embodiment, a feedback control of the beam current measurement to adapt the size of the continuously varying aperture opening size may also be conducted more often. For example the beam current could be measured during non-imaging times of the system. Thereby, a feedback to the motion element of the aperture arrangement can be provided on a more regular base, e.g., every minute or every second. Thereby, a quasi-continuous control of the beam current can be realized.

The embodiments related to aperture arrangements described herein have an on-axis beam blocking height that is significantly smaller than aperture arrangements, which deflect the electron beam to different aperture openings in order to vary the size of the aperture opening. The on-axis beam blocking height is to be understood as the distance along the beam propagation that is necessary for a beam to be deflected away from the optical axis to an aperture opening, for trespassing the height of the aperture element and for a beam deflection back onto the optical axis. Since the present invention is capable of providing a varying size aperture opening on the optical axis, a beam deflection away from the optical axis and back onto the optical axis can be omitted. Thus, the height of the overall system for the aperture element (including potential deflection units) can be significantly reduced. Thereby, the length of the electron beam column can be reduced or does not require additional length. A shorter column length can improve the imaging properties of the system.

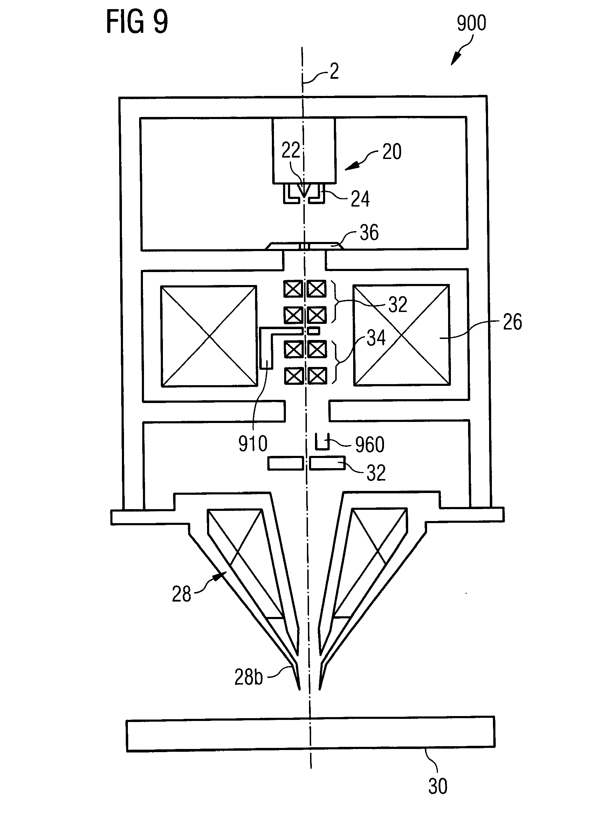

Generally, for the embodiments described herein, the variable size aperture arrangements according to the present invention can be provided with a space requirement on the optical axis that is significantly smaller as compared to common systems including multi-apertures and associated deflectors. The aperture arrangements of embodiments described herein have a height (on-axis beam blocking height) of below 40 mm, for example between 1 and 10 mm, typically 5 mm. For the embodiments described herein, it is particularly possible to have a small height close to the optical axis and have a larger height at portions of the holder or portions of the motion elements that can be provided distant from the optical axis. An example of an aperture arrangement with a small height on the optical axis and a larger height at a position about 2 cm to 10 cm distant from the optical axis is shown in Figure 9.

The embodiment of Fig. 9 shows an electron beam device 900. Electron gun 20 includes an emitter 22 and suppressor 24. The primary electron beam is emitted essentially along optical axis 2. The gun chamber housing is separated by aperture 36 from the following chamber. The aperture 36 can also act as an anode. The primary electron beam is formed and guided by condenser lens 26 and deflection units 32 and 34 for alignment of the primary electron beam. The primary electron beam passes through the opening in detector 32 and is focused by primary objective lens 28 including electrode 28B. The specimen 30 is provided below the objective lens. Within the embodiment of Fig. 9, aperture arrangement 910m which may be an aperture arrangement according to any of the embodiments described herein, is provided. The aperture arrangement requires only little space on the optical axis. Particularly, a variable size aperture arrangement can be provided without the requirement of much space in the column.

While the foregoing is directed to embodiments of the invention, other and further embodiments of the invention may be devised without departing from the basic scope thereof, and the scope thereof is determined by the claims that follow.

## Claims

1. A charged particle beam device adapted for variably controlling a beam current, comprising:
an emitter (22) for emitting a charged particle beam in a propagation direction essentially along an optical axis (2) of the charged particle beam device;
an aperture arrangement (100; 200; 300) within the charged particle beam device, the aperture arrangement comprises:
a first aperture element (102; 202; 502; 802) having a recess of the first aperture element, the first aperture element being movable in a first direction and with respect to the optical axis;
a second aperture element (104; 204; 504; 804) having a recess of the second aperture element, the second aperture element being movable in essentially the first direction and with respect to the optical axis;
a holder (320; 822) for holding the first aperture element and the second aperture element;
a motion element (230; 330; 330'; 830) adapted to move the first aperture element and the second aperture element with respect to the optical axis; and
wherein the first aperture element and the second aperture element are displaced with respect to each other along the propagation direction;
wherein the first aperture element and the second aperture element are movable in the first direction such that the recess of the first aperture element and the recess of the second aperture element form an aperture opening (110; 210) of a variable size.

2. Charged particle beam device according to claim 1, wherein the aperture opening is located essentially on the optical axis.

3. Charged particle beam device according to any of the preceding claims, wherein the first aperture element (102; 202; 502; 802) and the second aperture element (104; 204; 504; 804) are movable in the first direction such that the recess (103) of the first aperture element and the recess (105; 305) of the second aperture element form an aperture opening with a size varying symmetrical in the first direction with respect to the optical axis.

4. Charged particle beam device according to any of the preceding claims, wherein the first aperture element and the second aperture element are movable in the first direction such that the recess of the first aperture element and the recess of the second aperture element form an aperture opening with a size varying between 5 µm and 500 µm

5. Charged particle beam device according to any of the preceding claims, wherein the first recess and the second recess are triangular, and wherein the recess of the first aperture element (102; 202; 502; 802) and the recess of the second aperture element (104; 204; 504; 804) form an essentially quadratic aperture opening.

6. The charged particle beam device according to the previous claims, where in the aperture arrangement further comprises:
a first current terminal (750) of the first element and a second current terminal (752) of the first element to provide a current through the first element and a first current terminal (750) of the second element and a second current terminal (752) of the second element to provide a current through the second element;

7. Charged particle beam device according to any of the preceding claims, wherein the motion element (230; 330; 330'; 830) comprises at least one piezo element.

8. Charged particle beam device according to any of the preceding claims, wherein the motion element comprises at least one lever arm (222).

9. Charged particle beam device according to any of the preceding claims, further comprising a beam current measuring device, in the propagation direction, after the aperture arrangement.

10. Charged particle beam device according to any of the preceding claims, further comprising a control unit for the aperture arrangement being connected to the beam current measuring device is adapted to feedback the current of the charged particle beam.

11. Charged particle beam device according to any of the preceding claims, wherein the aperture arrangement (100; 200; 300) has an on-axis beam blocking height of between 1 mm and 50 mm.

12. Use of an aperture arrangement for a charged particle beam device adapted for variably controlling a beam current of a charged particle beam trespassing in a propagation direction essentially along on optical axis of the charged particle beam device, comprising:
moving a first aperture element (102; 202; 502; 802) and a second aperture element (104; 204; 504; 804) in a first direction with respect to each other such that a recess of the first aperture element and the recess of the second aperture element form an aperture opening of a variable size for trespassing of the charged particle beam, the aperture opening being located essentially on the optical axis.

13. The use according to claim 12, further comprising:
providing a current through the first aperture element and the second aperture element for heating the first aperture element and the second aperture element, wherein the current is provided in a parallel connection through the first element and the second element.

14. The use according to any of claims 12 to 13, wherein the current is provided during a time wherein the charged particle beam device is not in an image generating mode.

15. The use according to any of claims 12 to 14, wherein the current is provided during a time period of 60 seconds or less.

16. The use according to any of claims 12 to 15, wherein the current is provided to heat the first aperture element and the second aperture element to a temperature of 400°C to 850°C.

17. The use according to any of claims 12 to 16, wherein the beam is guided onto a parking position (642) located onto at least one element of the group consisting of: the first aperture element and the second aperture element.

18. The use according to any of claims 12 to 17, further comprising:
measuring the current trespassing through the aperture element; and
varying the size of the aperture element.

19. A method of manufacturing an aperture arrangement for a charged particle beam device adapted for variably controlling a beam current of a charged particle beam trespassing in a propagation direction essentially along on optical axis of the charged particle beam device, comprising:
providing a first aperture element (102; 202; 502; 802) and a second aperture element (104; 204; 504; 804) with a fixed position relative to each; and
thereafter forming a recess of the first aperture element and a recess of the second aperture element.

20. Method of manufacturing an aperture arrangement according to claim 19, further comprising:
displacing the first aperture element and the second aperture element with respect to each other along the propagation direction; and
thereafter separating the first aperture element and the second aperture element.

21. Method of manufacturing an aperture arrangement according to any of claims 19 to 20, wherein the first aperture element and the second aperture element are provided with a fixed position relative to each other by mounting the first aperture element and the second aperture element on a holder of the aperture arrangement and, thereafter, forming the recess of the first aperture element and the recess of the second aperture element.

22. Method of manufacturing an aperture arrangement according to any of claims 19 to 21, wherein the recess of the first aperture element and the recess of the second aperture element are formed before the first aperture element and the second aperture element are mounted to a holder and displaced with respect to each other along the propagation direction.
